# EUROPEAN PATENT APPLICATION

(11) **EP 4 002 699 A1**
(43) Date of publication of application: **25.05.2022**
(21) Application number: 20207459.7
(22) Date of filing: 13.11.2020
(51) Int. Cl.: H03M 1/06, G06F 1/10

(54) **APPARATUS AND METHOD FOR SYNCHRONIZING**

(71) Applicant: HENSOLDT Sensors GmbH, 82024 Taufkirchen (DE)
(72) Inventor: WINK, Alexander, 89584 Ehingen (DE); RAUSCHER, Jürgen, 89198 Westerstetten (DE)
(74) Representative: LifeTech IP Spies & Behrndt Patentanwälte PartG mbB

(57) **Abstract**

An apparatus for synchronizing comprises at least one converter device (100) including multiple converter units (no) for performing multiple samplings steps using the sampling clock signals (250) and a programmable logic (120) with a phase-locked loop, PLL, device (125), the programmable logic (120) being configured to pre-process signals for or from the converter units (110). The apparatus further comprises a clock device (200) configured to generate the sampling clock signal (250) based on a reference clock (150) and to generate a system reference signal (260) based on a request signal (160). The request signal (160) is generated by the PLL device (125) with a same phase as the reference clock (150) to synchronize the multiple converter units (110).

## Description

The present invention relates to an apparatus and a method for synchronizing sampling clock signals and, in particular, utilizing a temperature compensated zero-delay phase-locked loop (PLL) in a programmable logic to relax requirements from picoseconds to nanoseconds for the synchronization system reference signal of highspeed converters such as analog-digital converter (ADC) and digital-to-analog converter (DAC) interfaces in field programmable gate arrays (FPGAs) and so-called system-on-chips (SoC).

### BACKGROUND

For highspeed signal sampling and processing applications utilizing an array of synchronized ADCs (and similarly in DACs) the ability to deskew and to match so-called latency variations across the converter is very important. The latency variations relate, for example, to time variations that occur for data propagating from an input to a destination (output). These variations in time may be measured by clock periods of the respective device clock.

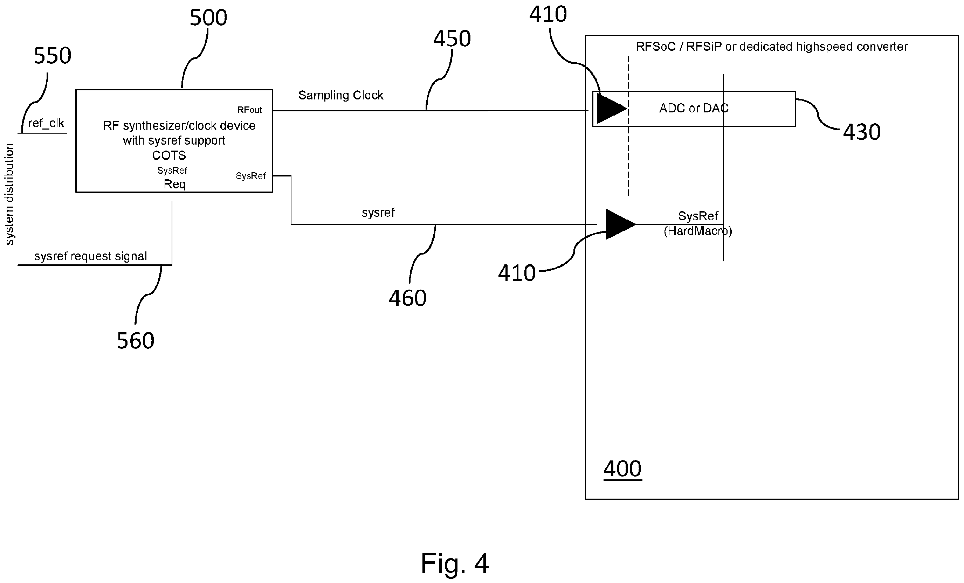

**Fig. 4** depicts a conventional device for synchronizing sampling clock signals 450 that are utilized in various converter units 430 of a dedicated highspeed converter 400. The sampling clock signals 450 are generated by a clock device 500 based on a reference clock (ref_clk) signal 550 provided by a system distribution. In addition, the clock device 500 receives a reference request signal 560 from the system distribution and, in response thereto, generates a system reference signal 460 (sysref). The system reference signal 460 is utilized in the highspeed converter 400 to synchronize the various converter units 430. The converter units 430 may be multiple ADCs or multiple DACs and the converter device 400 may be implemented as RFSoC (radio frequency SoC) or RFSiP (radio frequency SiP).

The clock signal 450 may be sent in parallel with data to be sampled. The clock signal 450 and sysref signal 460 will be amplified by amplifiers 410 before it can drive flip-flops to sample the data. This results in a finite, and process-, temperature-, and voltage-dependent delay between a detected clock edge and a received data window, and this delay will limit the frequency at which data can be sent.

Accordingly, conventional synchronizations need a high-level accuracy for the system reference request signal 460 with respect to the clock signals 450 to achieve a synchronization with a high level of accuracy. However, this cannot be achieved if the temperature varies which results in a drift for the signals contravening a desired sample-accurate synchronization.

As a result, conventional radio-frequency system-on-chip (RFSoC) devices and other highspeed ADCs and DACs guarantee at best only a synchronization of +/one sampling clock period, which is not sufficient in many situations such as digital beam forming applications in radar systems.

Therefore, there is a demand for an apparatus that allows a sample-accurate synchronization, and which is fast, robust and cost-efficient and can be applied for multiple ADCs and DACs within a device and across all devices in a front-end of the exemplary digital beam forming system.

### SUMMARY OF THE INVENTION

At least some of the above-mentioned problems are solved by an apparatus according to claim 1 and a corresponding method according to claim 9. The dependent claims refer to further advantageous realizations for the subject matters of the independent claims.

The present invention relates to an apparatus for synchronizing. The synchronizing may be used for sampling clock signals utilized in performing sampling steps in converters. The apparatus comprises at least one converter device including multiple converter units for performing multiple samplings using the sampling clock signals. The converter device further includes a programmable logic with a phase-locked loop, PLL, device. The programmable logic is configured to pre-process signals for or from the converter units. The apparatus further includes a clock device configured to generate the sampling clock signal based on a reference clock and to generate a system reference signal based on a request signal. The request signal is generated by the PLL device with a same phase as the reference clock to synchronize the multiple converter units.

According to further embodiments, the PLL device is a temperature compensated zero-delay phase-locked loop. The PLL device may be configured to align phases of the reference clock und the request signal for various frequency ranges. In particular, the reference clock may have a frequency in a range between 10 MHz and 1 GHz or between 50 MHz and 200 MHz or about 100 MHz.

According to yet another embodiment, the clock device is a radio frequency synthe sizer configured to generate the sampling clock signal with a frequency of at least 1 GHz or at least 5 GHz or at least 10 GHz based on the reference clock signal. Therefore, sampling clock signal has a significant higher frequency (e.g. by a factor of 100). But since the alignment is carried out for the lower frequencies of the request signal and the reference clock signal, synchronization requirements are significantly relaxed.

According to yet another embodiment, the converter units include multiple analog-to-digital converters, ADCs, and/or multiple digital-to-analog converters, DACs, wherein each ADC and/or each DAC is configured to perform a sampling based on the synchronized sampling clock periods. For many applications such as digital beam forming it is important that the multiple sample processes are carried out in a synchronized way.

According to yet another embodiment, the at least one converter device includes multiple converter devices, wherein the converter units in different converter devices are synchronized utilizing for each converter device its respective programmable logic. According to further embodiments, all converter devices with their converter units are synchronized with one of the available programmable logic.

According to yet another embodiment, the at least one converter device is a radio frequency system-on-chip (RFSoC) device or a radio frequency system-in-package (RFSiP) device.

Further embodiments relate to a digital beamforming device for a radar system. The beamforming device comprises an antenna array for transmitting and/or receiving of multiple radar signals. The beamforming device further includes an apparatus as defined before for synchronizing, wherein the apparatus is configured to synchronize the sampling processes for the multiple radar signals.

Further embodiments relate to a method for synchronizing of sampling clock signals utilized for performing of sampling steps for signals. The method comprises:
- performing multiple sampling steps by multiple converter units using the sampling clock signals;
- pre-processing of converted signals or generating signals for conversion by a programmable logic with a phase-locked loop, PLL, device;
- generating, by a clock device, the sampling clock signal based on a reference clock;
- generating, by the PLL device, a request signal with a same phase as the reference clock; and
- generating, by the clock device, a system reference signal based on the request signal to synchronize the multiple converter units.

It is understood that the method may include further or all steps performed by the apparatus as defined before. In addition, the order of the method steps shall not be restricted. The steps can be carried out in any order - at least as long as possible.

Embodiments solve at least some of the above-mentioned problems by utilizing a PLL in a programmable logic of the converter device. The PLL device is, in particular, a temperature compensated zero-delay PLL to relax the synchronization system reference signal requirements. Furthermore, a clock device is used to get the general signal sampled unambiguously in relation to a reference clock. This clock device may be a conventional wideband radio frequency synthesizer with a specific SYSREF generation support. Accordingly, an exact position of the converter clock relatively to the sampled time-domain samples received within the programmable logic can be detected and compensated over multiple converters and/or multiple devices.

Embodiments achieve thus the advantage that the requirements for the synchronization system reference (sysref) signal of highspeed ADCs and DACs interfaces and further logic parts can be relaxed from picoseconds to nanoseconds. This relaxation is achieved by using the reference clock for delay compensation and this reference clock is by factor 100 or more slower than the sampling clock signal. By relaxing the time requirements to nanoseconds, the needed device synchronization can be realized with established synchronization methods using programmable logic on FPGAs and SoCs. There is no need to distribute a specific system reference signal with very high timing requirements (i.e. in picosecond periods).

### BRIEF DESCRIPTION OF THE DRAWINGS

Various embodiments of the present invention will be described in the following by way of examples only, and with respect to the accompanying drawings, in which:
- Fig. 1: depicts an apparatus for synchronizing according to an embodiment.
- Fig. 2: illustrates further details of further embodiments for the apparatus.
- Fig. 3: shows a schematic flow chart for a method for synchronizing of sampling clock signals according to an embodiment.
- Fig. 4: depicts a convention apparatus for synchronizing of sampling clock signals according to an embodiment.

### DETAILED DESCRIPTION

Various examples will now be described more fully with reference to the accompanying drawings in which some examples are illustrated.

Accordingly, while examples are capable of various modifications and alternative forms, the illustrative examples in the figures and will herein be described in detail. It should be understood, however, that there is no intent to limit examples to the particular forms disclosed, but on the contrary, examples are to cover all modifications, equivalents, and alternatives falling within the scope of the disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing illustrative examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

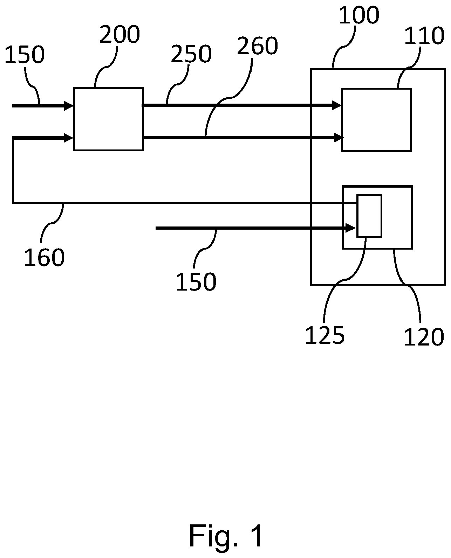

**Fig. 1** depicts an apparatus for synchronizing of sampling clock signals 250 according to an embodiment. The apparatus comprises at least one converter device 100 and a clock device 200. The at least one converter device 100 includes multiple converter units 110 and a programmable logic 120. The multiple convert units 110 are configure to perform multiple sampling processes based on the sampling clock signals 250. The programmable logic 120 includes a phase-locked loop, PLL, device 125 and is configured to pre-process converted signals from the converter units 110 or to generate signals for conversion in the converter units 110.

The clock device 200 is configured to generate a sampling clock signal 250 based on a reference clock 150 and to generate a system reference signal 260 based on a request signal 160. The generated sampling clock signal 250 may be amplified and distributed to the multiple conversion units 110. The request signal 160 is generated by the PLL device 125 with a same phase as the reference clock 150 to synchronize the multiple converter units 110. As a result, the rising edges of the request signal 160 and the reference clock 150 may be aligned.

Thus, according to embodiments, the synchronization is based on a phase alignment between the reference clock signals 150 and the request signal 160. Both signals have a significantly lower frequency than the sampling clock signals 250. For example, the sampling clock 250 may operate in a range of 10 GHz or more, whereas the reference clock signal 150 may comprise a frequency of 100 MHz. These two exemplary values may differ, but the frequency of the sampling clock 250 will in any case be larger, for example, by a factor of 100. The phase alignment in this lower frequency range (around 100 MHz or between 1 MHz and 1 GHz) can be achieved with the field programmable logic that is part of the converter device 100 without any significantly high requirements. This is a major advantage over the conventional devices.

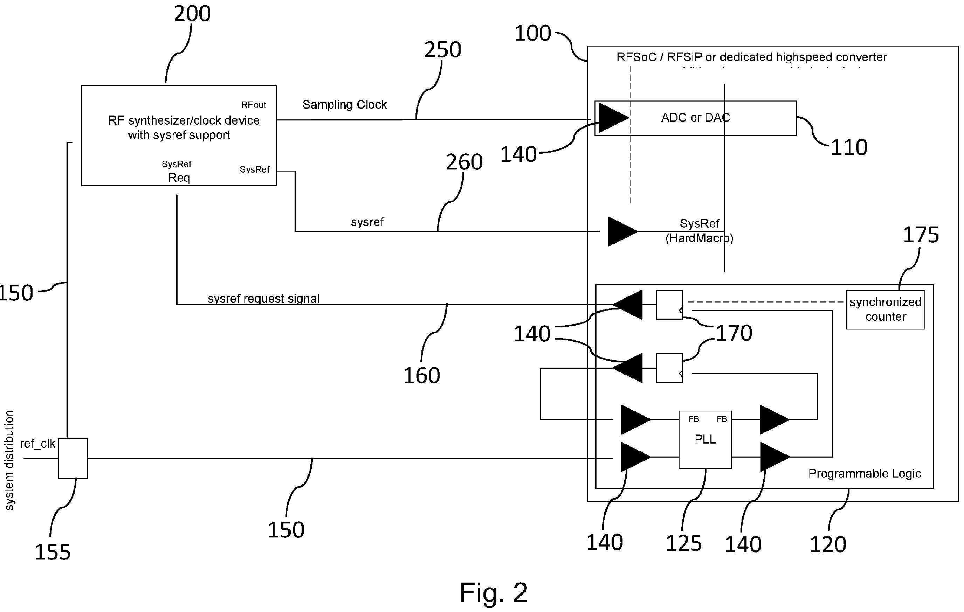

**Fig. 2** depicts additional details of the apparatus according to further embodiments. The converter device 100 includes a plurality of ADCs and/or DACs which are implemented in a system-on-chip (SoC) or in a system-in-package (SiP) device. Both may process radio frequency signals and may thus be referred to as RFSoC or RFSiP. According to embodiments, the RFSoC is an integrated circuit (a "chip") that integrates all or most components of a computer or other electronic system. Similarly, the RFSiP may include a number of integrated circuits enclosed in one or more chip carrier packages that may be stacked using package on package.

According to the depicted embodiment, the converter device 100 includes the programmable logic 120 with the PLL device 125 which receives the reference clock signal 150 and generates the system request signal 160 so that the phases (or the signal edges) of the request signal 160 and the reference clock 150 are aligned. The reference clock 150 (ref_clk) is provided by a system distribution and/or a distribution unit 155.

According to embodiments, a strict phase relation between the request signal 160 and the reference clock 150 will be ensured - even if the temperature of the converter device 100 changes with time. For this, the programmable logic 120 includes, in particular, a zero-delay temperature compensated PLL 125 to compensate for latency variations caused by various amplifier 140 and register flipflop devices 170 and other sources in the converter device 100. A synchronized counter 175 provides the time base for generating the (sysref) request signal 160 in the programmable logic 120. If several converter devices 100 are to be synchronized, then the synchrony of the counters in the converter devices 100 is a prerequisite. However, since this counter 175 runs on the basis of the reference clock (slow rate) 150, the synchronization of the individual counters 175 across the interfaces of the programmable logic 120, such as e.g. Ethernet, is easily realizable. The generation of the sysref request signal 160 via the synchronized counters 175 thus replaces the central generation and analog distribution in the conventional system (see Fig. 4, signal 560). At the same time, the counter 175 is typically also used operationally when a signal shall be transmitted simultaneously (= sample-synchronized) on all DACs or to start simultaneously the evaluation of the received data (ADCs).

Since, according to embodiments, the programmable logic 120 is integrated in the RFSoC or RFSiP the generated request signal 160 will automatically take into account temperature variations and maintains the defined phase relation between the reference clock 150 and the reference request signal 160. Consequently, any latency variations caused, for example, by temperature variations of the amplifiers 140 and/or other devices in the RFSoC/RFSiP will automatically be compensated. Therefore, the sample-accurate synchronization can be ensured. In contrast hereto, in the conventional apparatus of Fig. 4, the system request signal is provided by an external source so that temperature variations cannot be taken into account. Temperature dependent effects of the conventional system distribution (see signals 560, 550 in Fig. 4) cannot be compensated. In addition, setup and hold times for the conventional converter device 400 (see Fig. 4) can typically not be ensured automatically.

Therefore, embodiments achieve the elimination of delays by using the integrated PLL 125 to generate the request signal 160 and, subsequently, the system reference signal 260.

According to further embodiments the at least one converter device 100 is not only a single device, but may comprise multiple devices so that the synchronization can be achieved even over multiple devices. With the help of the synchronized counters 175 several converter devices 100 can be synchronized. For this, several clock devices 200 can be used (typically one clock device 200 per converter device 100).

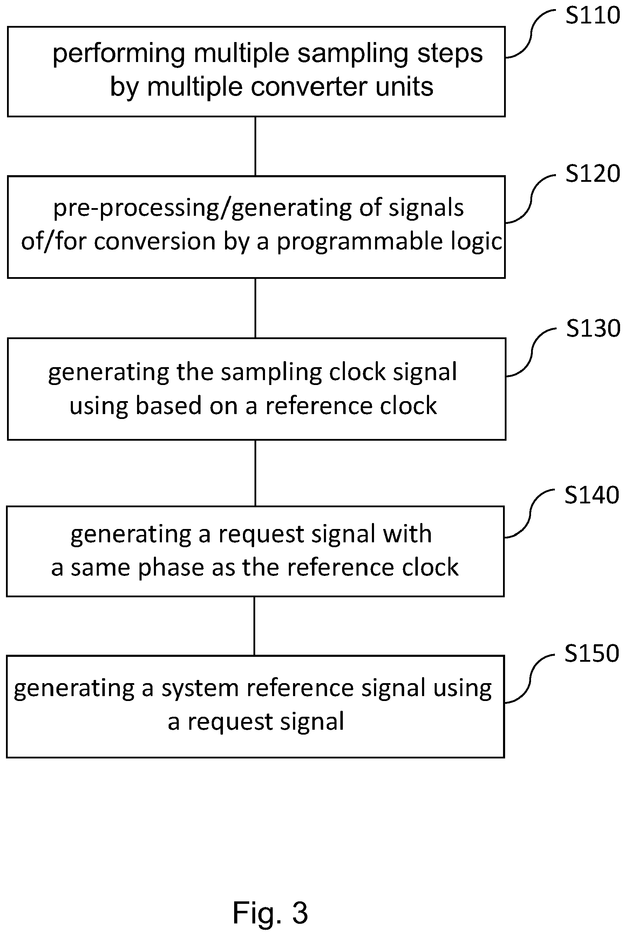

**Fig. 3** shows a schematic flow chart for a method for synchronizing of sampling clock signals according to an embodiment. The method comprising:
- multiple sampling steps S110 by multiple converter units 110 based on the clock periods;
- pre-processing S121 of converted signals or generating S122 signals for conversion by a programmable logic 120 with a phase-locked loop, PLL, device 125;
- generating S130, by a clock device 200, a sampling clock signal 250 based on a reference clock 150; and
- generating S140, by the PLL device 125, a request signal 160 with a same phase as the reference clock 150; and
- generating S150, by the clock device 200, a system reference signal 260 based on a request signal 160 to synchronize the multiple converter units 110.

It is understood that all functions descripted before in conjunction with the apparatus can be, according to further embodiments, additional optional method steps. Moreover, as long as it is possible, the order of steps can be arbitrary.

Embodiments provide at least the following advantages:
- Embodiments overcome the accuracy of only +/- one sampling clock period synchronization of conventional RFSoC. There is no need to distribute a unique or specific system reference synchronization signal to all ADCs and DACs in the front end. There is no need for a global sysref signal 260 or a sysref request signal 160, which is within a 100 ps time window.
- In contrast to conventional systems, there is no need to sample the specific system reference synchronization signal within a time window of, e.g., 100 picoseconds if the converter runs at, for example, at 10 GHz or 10 GSPS (giga samples per second).
- Embodiments implement an automatic temperature compensation which in conventional devices is not realizable.
- Embodiment meet the accuracy requirements of modern highspeed sampling processes.
- The synchronization accuracy beyond the specific device values can be achieved for devices such as Xilinx RFSoC.

Furthermore, while each embodiment may stand on its own as a separate example, it is to be noted that in other embodiments the defined features can be combined differently, i.e. a particular feature descripted in one embodiment may also be realized in other embodiments. Such combinations are covered by the disclosure herein unless it is stated that a specific combination is not intended.

The description and drawings merely illustrate the principles of the disclosure. It will thus be appreciated that those skilled in the art will be able to devise various arrangements that, although not explicitly described or shown herein, embody the principles of the disclosure and are included within its scope.

The preceding description and the description of the figures enable the person skilled in the art to implement the exemplary embodiments in concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention, which is defined by the claims and their legal equivalents, such as further explanations in the description.

### List of reference signs

- 100: at least one converter device
- 110, 430: multiple converter units
- 115: distribution unit
- 120: programmable logic
- 125: phase-locked loop (PLL) device (125)
- 140, 410: amplifier
- 150, 550: reference clock
- 160: request signal
- 170: register flip-flops
- 175: synchronized counter
- 200: clock device
- 250, 450: sampling clock signal
- 260, 460: system reference signal
- 400: conventional converter device
- 500: conventional clock device

## Claims

1. An apparatus for synchronizing, the apparatus comprising:
at least one converter device (100) including multiple converter units (110) for performing multiple samplings using a sampling clock signal (250) and a programmable logic (120) with a phase-locked loop, PLL, device (125), the programmable logic (120) being configured to pre-process signals for or from the converter units (110);
a clock device (200) configured to generate the sampling clock signal (250) based on a reference clock (150) and to generate a system reference signal (260) based on a request signal (160),
wherein the request signal (160) is generated by the PLL device (125) with a same phase as the reference clock (150) to synchronize the multiple converter units (110).

2. The apparatus according to claim 1, wherein the PLL device (125) is a temperature compensated zero-delay phase-locked loop.

3. The apparatus according to claim 1 or claim 2, wherein the PLL device (125) is configured to align phases of the reference clock (150) und the request signal (160) when the reference clock (150) has a frequency in a range between 10 MHz and 1 GHz, or between 50 MHz and 200 MHz, or about 100 MHz.

4. The apparatus according to one of the preceding claims, wherein the clock device (200) is a radio frequency synthesizer configured to generate the sampling clock signal (250) with a frequency of at least 2 GHz, or at least 5 GHz, or at least 10 GHz based on the reference clock signal (150).

5. The apparatus according to one of the preceding claims, wherein the converter units (110) include multiple analog-to-digital converters, ADCs, and/or multiple digital-to-analog converters, DACs, wherein each ADC and/or each DAC is configured to perform a sampling based on the synchronized sampling clock signal (250).

6. The apparatus according to one of the preceding claims, wherein the at least one converter device (100) includes multiple converter devices, wherein the converter units (110) in different converter devices (100) are synchronized utilizing for each converter device (100) its respective programmable logic (120).

7. The apparatus according to one of the preceding claims, wherein the at least one converter device (100) is a radio frequency system on a chip, RFSoC, or a radio frequency system in package, RFSiP.

8. A digital beamforming device for a radar system with:
an antenna array for transmitting and/or receiving of multiple radar signals; and
an apparatus for synchronizing according to one of the preceding claims, wherein the apparatus is configured to synchronize the sampling process for the multiple radar signals.

9. A method for synchronizing, the method comprising:
performing multiple sampling steps (S110) by multiple converter units (110) using the sampling clock signals (250);
pre-processing of converted signals or generating signals for conversion (S120) by a programmable logic (120) with a phase-locked loop, PLL, device (125);
generating (S130), by a clock device (200), the sampling clock signal (250) based on a reference clock (150);
generating (S140), by the PLL device (125), a request signal (160) with a same phase as the reference clock (150); and
generating (S150), by the clock device (200), a system reference signal (260) based on a request signal (160) to synchronize the multiple converter units (110).
